# EUROPEAN PATENT SPECIFICATION

(11) **EP 0 447 082 B1**
(45) Date of publication and mention of the grant of the patent: **04.01.1995**
(21) Application number: 91301752.1
(22) Date of filing: 04.03.1991
(51) Int. Cl.: H05K 13/00

(54) **Die presentation system for die bonder**
Chip-Zuführungssystem für Chipkontaktierer
Système de distribution de cube pour connecteur de cube

(30) Priority: 16.03.1990 GB 9006036
(43) Date of publication of application: 18.09.1991
(73) Proprietor: F & K Delvotec Bondtechnik GmbH, D-82041 Oberhaching (DE)
(72) Inventor: Schweitzer, Karl, A-6300 Angerberg (AT); Zeindl, Gerhard, A-6232 (AT)
(74) Representative: MEISSNER, BOLTE & PARTNER

(56) References cited:
- EP-A- 0 130 498
- US-A- 3 894 671
- US-A- 4 653 664

## Description

The present invention relates to a die presentation package exchange system for a hybrid die bonder, in particular an automatic hybrid die bonder.

A hybrid die bonder is used for bonding semiconductor dice of a range of different types and, in particular, sizes to a substrate. At the die presentation stage, dice are presented one at a time to a die eject head, for ejection and subsequent retrieval by an appropriate pick-up tool. A number of different die presentation systems are known and used, and the choice of die presentation system is determined principally by the size of the die. Available die presentation systems include for example wafer rings, film frames and waffle packs, each of which is available in different sizes.

In automatic hybrid die bonding, it is necessary for the machine to be able to handle a number of different sizes or types of dice with as short as possible an interval, and consequent loss of operating time of the machine, when changing from handling one size or type of die to another.

Known die presentation systems include wafer rings, film frames and waffle packs; each individual wafer, frame or pack contains dice of only one type or size, so that when during bonding it is necessary to change from one die type or size to another, it is also necessary to change to a different die presentation package, although it may be a similar type of package, the only difference being in the dice presented. In known hybrid die bonding machines, the die presentation packages are changed manually with consequent loss of production.

It is an object of the present invention to provide a die presentation system in which the above disadvantages are reduced or substantially obviated.

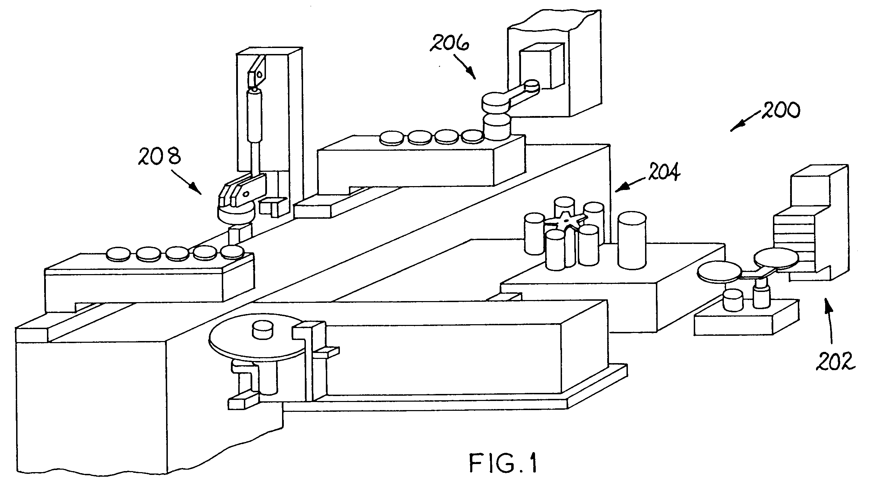

The present invention provides a die presentation package exchange system for use in a hybrid die bonding machine, in particular an automatic hybrid die bonding machine. An automatic hybrid die bonder, as shown in Figure 1, suitably comprises a die presentation system according to the present invention, shown generally at 202, a die eject station shown generally at 204 and a die pick-up and mounting system, which may be die collet system (206) or an epoxy die bonder (208).

The die eject station (204) suitably comprises a die eject system such as the die eject system described and claimed in our European Patent Application EP-A-0 447 083 of even date herewith, which system comprises a support, a plurality of die eject heads mounted on the support, and means for indexing increment of the support to index a die eject head into an operative position. The different die eject heads comprise different arrangements of die eject needles, each of which is suitable for ejecting a particular size or type of die.

After ejection at the die eject station (204), the die is picked up by a suitable pick-up and taken to a die mounting station. An automatic hybrid die bonder preferably comprises both a die collet mounting station (206) and an epoxy print station (208). The die pick-up stage suitably comprises a tool exchange system such as that described and claimed in our European Patent Application EP-A-0 447 087 of even date herewith, which comprises a tool bank (120,122) comprising a plurality of tool holders (124,126) each fitted with a tool and adapted for pick-up by a head (128). The head (128) is mounted on a support and can be driven between the tool bank (120,122), the die eject station (104) according to the present invention and a die mounting station (106,108). The tool bank (120,122) can be driven to index a selected tool holder to a station at which it can be picked up by the head (128). The die presentation package exchange system according to the present invention comprises
(a) a magazine for storing a plurality of die presentation packages
(b) clamp assembly, mounted on an axial pin, rotatable about its vertical axis, comprising first and second clamp means mounted on a rotatable support, each of said clamps being adapted to collect a selected die presentation package from said magazine, feed it to a die eject station of said die bonding machine, retrieve it from the die eject station after a predetermined number of dice have been ejected and return it to said magazine
(c) indexing means for indexing movement of the packages within the magazine (a) so that the selected package is located at a collection point for collection from the magazine and
(d) indexing means for indexing rotation of the clamp assembly (b) about said vertical axis.

A preferred embodiment of a die presentation package system according to the invention will now be further described with reference to the accompanying drawings in which:
Figure 1 is a general view of an automatic hybrid die bonding machine;
Figure 2 is a view, in section, of a magazine for storing a plurality of die presentation packages;
Figure 3 is a view, in section of a rotary clamp unit;
Figure 4 is a plan view of the rotary clamp unit of Figure 3;
Figure 5 is a view of a holder for die presentation packages and
Figure 6 is a diagrammatic representation of an operating cycle of the rotary clamp unit of Figures 3 and 4.

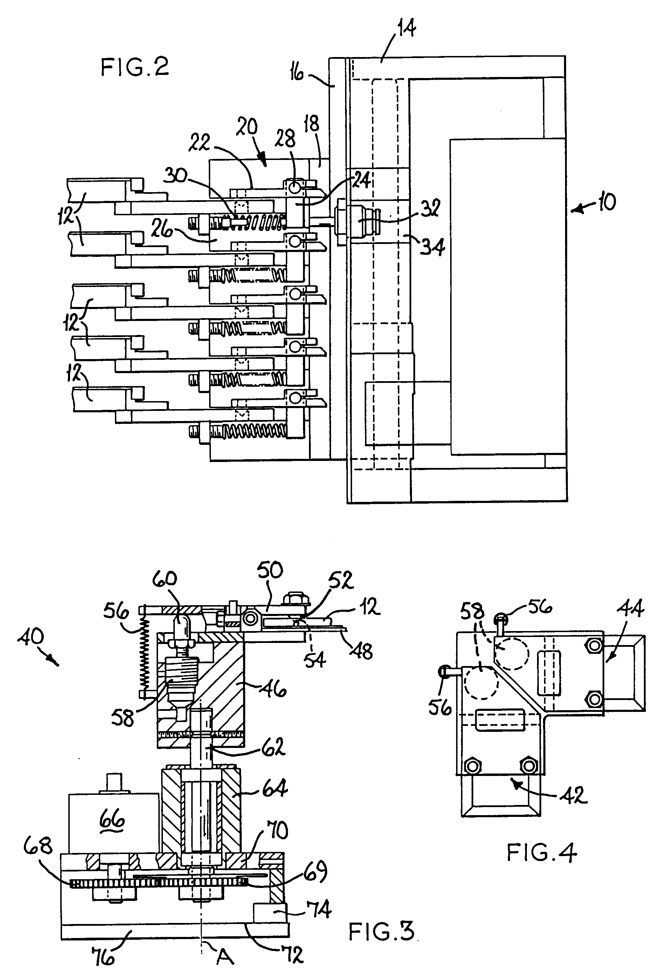

A magazine (10) as shown in Figure 2 comprises a storage and supply magazine for five or more die presentation packages (12). The magazine (10) comprises a fixed framework (14), one wall of which comprises a connector plate (16). A carrier plate (18) is mounted for vertical sliding movement on the connector plate (16).

A plurality of clamp assemblies (20), one for each die presentation package, are mounted vertically one above each other on the carrier plate (18). Each of these clamp assemblies (20) comprises a clamp lever (22), lever stop (24) and support plate (26). The clamp lever (22) is mounted so that it is rotatable about a shaft (28) between a clamping position, as shown in Figure 1 in which it clamps the die presentation package (12) and a release position (not shown) in which it releases the die presentation package. The clamp lever (22) is biased by a compression spring (30) towards the clamping position. The lever stop (24) limits the rotatory movement of the clamp lever (22). The compression spring (30) is mounted within the support plate (26).

A cylinder (32) is located within a housing (34) mounted to one side of the fixed framework (14). The operation of the magazine (10) will be described in more detail hereinafter.

As is shown in Figures 3 and 4, the die presentation package exchange system further comprises a rotatable clamp assembly (40). This unit comprises a first and second clamp means (42, 44) mounted at 90° to each other on a rotatable support (head) (46).

Each of said first and second clamp means (42, 44) comprises a clamp plate (48) on which is mounted a clamp piece (50). The clamp piece (50) is provided with two centering cones (52) which co-operate with corresponding recesses (54) on the die presentation package (12). The clamp plate (48) and clamp piece (50) are biased open by means of a spring (56).

Two short-stroke cylinders (58), each with an associated pressure piece (60), are mounted on the head (46), one beneath the first clamp means (42) and the other beneath the second clamp means (44), for closing the clamp means.

The head (46) is mounted on an axial pin (62) for rotation about a vertical axis (A) located in a housing (64). The head (46) is driven for rotation by a stepping motor (66) connected to the axial pin (62) by first and second toothed wheels (68,69).

The housing (64) is mounted on a base plate (70) beneath which the toothed wheels (68) and (69) are located. Rotation of the axial pin (62) is controlled by the stepping motor (66) and a position sensor (74).

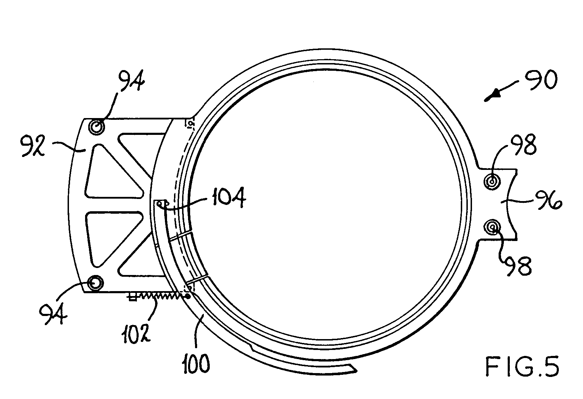

As shown in Figure 5, the die presentation package system further comprises a package holder (90) which is generally circular in shape. A flange (92) with centering recesses (94) forms an extension to one side of the circle and, on the opposite side of the circle a second flange (96) with centering recesses (98) similarly forms an extension to that side of the circle. A retaining arm (100) is mounted on the holder (94) by a pivot bolt (104) and is pulled by a spring (102) against the centre of the circle, to restrain movement of the die package.

The die presentation package exchange system forms part of an automatic hybrid die bonder (200) as shown in Figure 1 of the accompanying drawings. The die bonder briefly comprises a die presentation package exchange system (202) according to the present invention, which presents a die presentation package to a die eject station (204) as described and claimed in our co-pending GB Patent Application No. (F.15094) of even date herewith. The dice are presented to the die eject head by the presentation package, and are ejected by means of needles in the die eject head to be picked up by the tool (206, 208) of the pick-up system and taken either to the die collet mounting station.

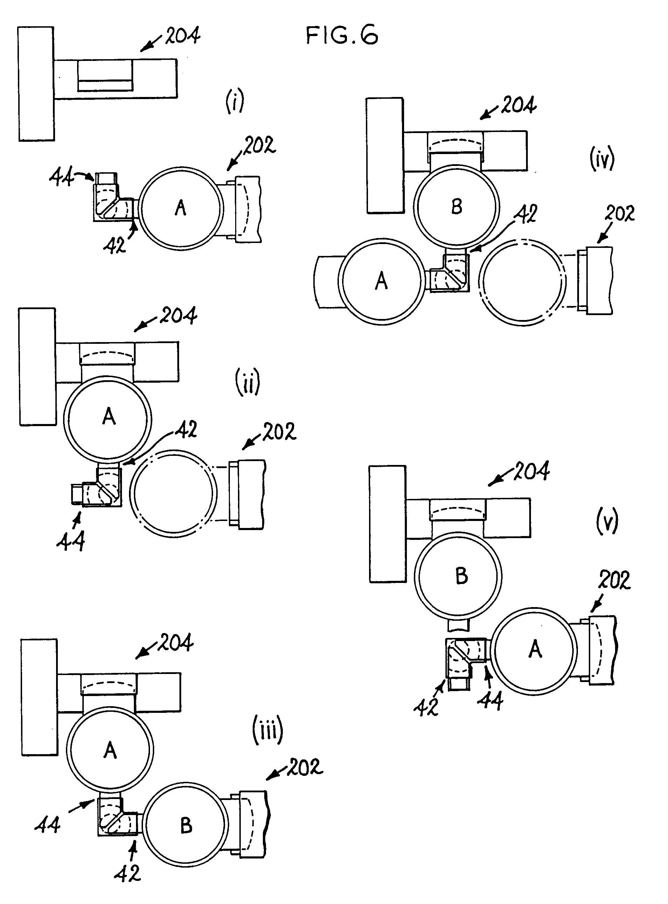

In operation, the carrier plate (18) is driven by means of a DC motor to the vertical position in which a selected die presentation package (12) is at the correct vertical location for supply to the rotatable clamp assembly (40). As shown in Figure 6 of the accompanying drawings, the rotatable clamp assembly (40) is located in a first rotary position (i) in which a package (A) is received in the first clamp means (42) and released by the clamp assembly (20) of the magazine (10). The rotatable head is then rotated through 90° in the anti-clockwise direction to a second rotatory position (ii) at which the package (A) is received by the die eject station (204) and released by the clamp means (42). The head is then rotated through 90° in the clockwise direction so that the clamp means (42) is again aligned with the magazine (10) as in position (iii). The carrier plate (52) is simultaneously driven by the DC motor to the vertical position in which a second selected die presentation package (B) is at the correct vertical location for supply to the clamp assembly (40). The package (B) is received in the first clamp means (42) and released by the clamp assembly of the magazine (10).

The unit is then held in this orientation until the predetermined number of dice have been removed from the package (A). The package (A) is then picked up by the clamp means (44), the head is rotated through 90° in the anti-clockwise direction (position iv) and the package (B) is then supplied to the die eject station. The head is then rotated through a further 180° in the anti-clockwise direction to return package (A) to the magazine, (position v) which has been driven to the correct vertical location for package (A) to be returned to its correct clamp assembly (20). The cycle is then repeated as required from position (iii) to position (v).

By following the operating cycle described above, it is possible to operate a hybrid die bonder with very much reduced down time between bonding different types of dice.

## Claims

1. A die presentation package exchange system for use in a hybrid die bonding machine, characterised in that the system comprises
(a) a magazine (10) for storing a plurality of die presentation packages (12),
(b) a clamp assembly (40) mounted on an axial pin(62) rotatable about its vertical axis (A) comprising first clamp means (42) and second clamp means mounted on a rotatable support (46), each of said clamp means (42,44) being adapted to collect a selected die presentation package (12) from said magazine (10), feed it to a die eject station (204) of said die bonding machine, retrieve it from the die eject station (204) after a predetermined number of dice have been ejected and return it to said magazine (10),
(c) indexing means for indexing movement of the packages (12) within the magazine (10) so that the selected package is located at a collection point for collection from the magazine (10) and
(d) indexing means for indexing rotation of the clamp assembly (40) about said vertical axis (A).

2. A die presentation package exchange system according to claim 1, characterised in that the magazine (10) is adapted to store at least five die presentation packages (12).

## Patentansprüche

1. Chipzuführungsgehäuse-Auswechselsystem zur Verwendung in einer Hybrid-Chipbondmaschine, dadurch gekennzeichnet, daß das System aufweist:
(a) ein Magazin (10), um eine Vielzahl von Chipzuführungsgehäusen (12) zu speichern,
(b) eine Einspannanordnung (40), die auf einem axialen Zapfen (62), der um seine Vertikalachse (A) drehbar ist, angebracht ist und eine erste Einspanneinrichtung (42) und eine zweite Einspanneinrichtung aufweist, die an einer drehbaren Halterung (46) angebracht sind, wobei jede Einspanneinrichtung (42, 44) ausgebildet ist, um ein ausgewähltes Chipzuführungsgehäuse (12) von dem Magazin (10) abzuholen, es einer Chipauswerfstation (204) der Chipbondmaschine zuzuführen, es aus der Chipauswerfstation (204) wieder aufzunehmen, nachdem eine vorbestimmte Anzahl Chips ausgeworfen worden ist, und es zu dem Magazin (10) zurückzubringen,
(c) eine Schalteinrichtung zum Weiterbewegen der Gehäuse (12) in dem Magazin (10), so daß das gewählte Gehäuse an einem Abholpunkt zur Abholung aus dem Magazin (10) positioniert wird, und
(d) eine Schalteinrichtung zum Weiterdrehen der Einspannanordnung (40) um die genannte Vertikalachse (A).

2. Chipzuführungsgehäuse-Auswechselsystem nach Anspruch 1, dadurch gekennzeichnet, daß das Magazin (10) ausgebildet ist, um wenigstens fünf Chipzuführungsgehäuse (12) zu speichern.

## Revendications

1. Système d'échange de boîtiers de présentation de puces destiné à être utilisé dans une machine de soudage de puces hybride, caractérisé en ce qu'il comprend :
a) un magasin (10) pour stocker plusieurs boîtiers de présentation de puces (12);
b) un ensemble de bridage (40), monté sur une broche axiale (62) pouvant tourner autour de son axe vertical (A), comprenant des premiers moyens de bride (42) et des seconds moyens de bride montés sur un support rotatif (46), les uns et les autres (42, 44) étant adaptés pour retirer un boîtier de présentation de puces sélectionné (12) de ce magasin (10), pour l'amener à un poste d'éjection de puces (204) de cette machine de soudage de puces, pour le retirer de ce poste d'éjection de puces (204) après éjection d'un nombre prédéterminé de puces et pour le ramener au magasin (10),
c) des moyens d'indexation pour indexer le mouvement des boîtiers (12) à l'intérieur du magasin (10) de façon que le boîtier sélectionné se trouve à un point de retrait pour être retiré du magasin (10); et
d) des moyens d'indexation pour indexer la rotation de l'ensemble de bridage (40) autour de l'axe vertical (A).

2. Système d'échange de boîtiers de présentation de puces selon la revendication 1, caractérisé en ce que le magasin (10) est adapté pour stocker au moins cinq boîtiers de présentation de puces (12).
